Europäisches Patentamt

(19) European Patent Office

Office européen des brevets

(11) Numéro de publication: **0 214 015**
**B1**

(12) **FASCICULE DE BREVET EUROPEEN**

(45) Date de publication du fascicule du brevet: **30.05.90**

(51) Int. Cl.⁵: **G 01 R 27/06**

(21) Numéro de dépôt: **86401708.2**

(22) Date de dépôt: **31.07.86**

(54) **Appareil de mesure d'impédance en haute fréquence.**

(30) Priorité: **02.08.85 FR 8511886**

(43) Date de publication de la demande:
**11.03.87 Bulletin 87/11**

(45) Mention de la délivrance du brevet:
**30.05.90 Bulletin 90/22**

(84) Etats contractants désignés:
**DE FR GB NL**

(56) Documents cités:
**FR-A-2 497 947**
**US-A-3 986 113**
**US-A-4 506 209**

**I.E.E. PROCEEDINGS SECTION A a I, vol. 129, no.
6, partie H, décembre 1982, pages 363-366, Old,
Woking, Surrey, GB; M.A. WOOD:
"Measurement of seattering parameters at 35
GHz using amplitude-modulated homodyne
detection"**

(73) Titulaire: **CENTRE NATIONAL DE LA
RECHERCHE SCIENTIFIQUE (CNRS)**
**15, Quai Anatole France**
**F-75007 Paris (FR)**

(72) Inventeur: **Solal, Daniel**
**162, rue Perronet**
**F-92200 Neuilly S/Seine Hauts de Seine (FR)**
Inventeur: **Bolomey, Jean-Charles**
**6, rue Berthollet**
**F-75005 Paris (FR)**

(74) Mandataire: **Bloch, Gérard et al**
**2, square de l'Avenue du Bois**
**F-75116 Paris (FR)**

# EP 0 214 015 B1

**Description**

L'invention concerne un appareil de mesure d'impédance en haute fréquence, applicable d'une manière générale à la mesure d'impédances de corps de toutes natures et, particulièrement bien adapté à la mesure d'impédance dans le cadre de l'hyperthermie.

Les mesures d'impédance présentent un intérêt fondamental dans le domaine de l'hyperthermie, où le problème consiste à dissiper dans le corps humain, où dans des régions localisées de celui-ci, une puissance électromagnétique fournie par un générateur, et appliquée à la région à traiter par l'intermédiaire d'électrodes d'application, cette puissance électromagnétique servant à élever la température des tissus.

La partie ainsi traitée constitue, vue des électrodes d'application, une charge d'impédance inconnue qui intervient très directement dans le transfert de puissance du générateur vers la charge; la fréquence des ondes électromagnétiques couramment utilisée en hyperthermie, étant comprise entre environ un MHz et quelques dizaines de MHz, restant généralement inférieure à 50 MHz.

A ce jour, la mesure en partie réelle et en partie imaginaire de l'impédance de la zone à traiter par hyperthermie, utilise des moyens dérivés des moyens de mesure d'impédance en basse fréquence; ces moyens étant tels que par exemple, des montages de pont d'impédance mis en oeuvre selon une méthode de zéro ou une méthode de substitution. Mais l'utilisation de ces moyens à des fréquences relativement élevées, oblige à prendre des précautions qui restent insuffisantes, telles que: blindage des éléments susceptibles d'être soumis à un rayonnement haute fréquence, réduction au maximum des inductances parasites et, interprétation judicieuse des résultats, compte tenu de toutes les perburbations qu'il n'est pas possible d'éliminer.

Ceci conduit à de nombreuses et longues manipulations qui peuvent s'avérer préjudiciable pour le patient, l'interprétation des résultats étant elle-même très délicate. Comme un traitement en hyperthermie peut exiger le traitement consécutif de plusieurs zones, lesquelles zones peuvent comporter des impédances différentes, la rapidité et la précision avec laquelle ces impédances sont déterminées, représentent des conditions de premières importances très imparfaitement remplies à ce jour.

A des fréquences beaucoup plus élevées, comme en hyperfréquence où la longueur d'onde est beaucoup plus faible, l'impédance inconnue Z chargeant l'extrémité d'une ligne peut être déterminée, après l'étude de la distribution en intensité du champ électrique en différents points de la ligne; la désadaptation entre l'impédance caractéristique $Z_c$ de la ligne et l'impédance de charge Z, engendrant un système d'ondes stationnaires.

La mesure des ondes stationnaires permet de déduire un coefficient de réflexion $p=R\ e^{j\varphi}$, R étant le module et $\varphi$ l'argument de ce coefficient de réflexion; ce dernier étant lié à l'impédance Z par la relation $p=(Z-Z_c)/(Z+Z_c)$, il permet de déterminer l'impédance de charge Z inconnue.

Pour trouver le coefficient de réflexion $\rho$, une méthode très connue consiste à déplacer le long de la ligne une sonde de mesure, permettant de mesurer l'intensité de champ en différents points de cette ligne et de connaître d'amplitude des maxima et des minima de champ. Le rapport d'amplitude des maxima à celle des minima est appelé taux d'onde stationnaire, d'où il est déduit le module du coefficient $\rho$; l'argument de ce dernier étant déduit d'une mesure de la distance entre l'extrémité de la ligne et le premier maximum de champ.

La méthode précédente a cependant pour inconvénient d'impliquer une suite de manipulations longues et délicates et, compte tenu des longueurs d'onde relativement grandes utilisées en hyperthermie, sa mise en oeuvre dans ce domaine nécessiterait un appareil d'un encombrement considérable.

Pour éviter ces inconvénients, en pout utiliser des appareils dérivés de ceux décrits dans les brevets US n° 3 986 113 et n° 4 506 209, et dans l'article de WOOD "Measurement of scattering parameters at 35 GHz using amplitude modulated homodyne detection" publié dans IEE PROC, Vol. 129, Pt. H, N° 6, December 1982, pages 363—366.

Ces appareils ont cependant pour inconvénient le fait qu'ils doivent être utilisés avec un générateur adapté, de puissance fixe, ce qui en exclut l'utilisation dans des domaines tels que l'hyperthermie où l'on opère à puissance variable (de 1 jusqu'à 1000 environ). En outre, les mélangeurs qu'ils comportent nécessitent des niveaux de puissance pratiquement constants, contrainte que l'on ne peut satisfaire qu'en laboratoire, et non pas en milieu hospitalier où l'appareil doit être manipulé par des opérateurs n'ayant généralement pas de qualification en électronique.

La présente invention a pour objet un appareil de mesure du type précité, pouvant être utilisé avec un générateur non adapté fournissant des puissances variables, nécessitant les réglages les plus simples possibles, et pourvant s'adapter automatiquement à un grande nombre de cas d'utilisation, sur une large gamme de fréquences, sans exiger un opérateur hautement qualifié, pour des applications en hyperthermie biomédicale ou de tout autre type, notamment industriel.

A cet effet, la présente invention a pour objet un appareil de mesure d'impédance en haute fréquence, comportant au moins un coupleur bidirectionnel, un générateur d'une onde haute fréquence de puissance variable, des atténuateurs variables, deux mélangeurs, des diviseurs de puissance dont l'un est un diviseur de puissance à déphasage de 90° entre ses deux sorties, chacune d'elles étant reliée à une entrée d'un respectif dex deux mélangeurs, caractérisé par le fait que:

—un premier coupleur bidirectionnel est intercalé, à l'aide de tronçons de lignes d'impédance

2

caractéristique $Z_c$ connue, entre le générateur d'une onde haute fréquence de puissance variable et des électrodes entre lesquelles est placé un corps dont l'impédance Z, inconnue, est à mesurer,

—la première voie couplée dudit premier coupleur, mesurant l'onde incidente sur l'impédance Z, est reliée, par l'intermédiaire d'un second coupleur bidirectionnel et d'un inverseur simple, soit à une impédance d'un des types suivants: impédance nulle et impédance pratiquement infinie, soit à une première charge adaptée,

—la seconde voie couplée dudit premier coupleur, mesurant l'onde réfléchie par l'impédance Z, est reliée, par l'intermédiaire d'un premier inverseur d'un inverseur double, soit à une deuxième charge adaptée, soit, par l'intermédiaire d'un premier atténuateur variable, à l'entrée d'un premier diviseur de puissance sans déphasage entre ses deux sorties reliées aux entrées RF des deux mélangeurs,

—la première voie couplée dudit second coupleur, mesurant l'onde incidente vers ledit inverseur simple, est reliée, par l'intermédiaire d'un second atténuateur variable, à l'entrée d'un second diviseur de puissance à déphasage de 90° entre ses deux sorties reliées aux entrées d'oscillateur local OL des deux dits mélangeurs,

—la seconde voie couplée dudit second coupleur, mesurant l'onde réfléchie à partir dudit inverseur simple, étant reliée, par l'intermédiaire du deuxième inverseur dudit inverseur double, soit à l'entrée dudit premier atténuateur lorsque ladite seconde voie couplée dudit premier coupleur est reliée à ladite deuxième charge adaptée, soit à une troisième charge adaptée lorsque ladite seconde voie couplée dudit premier coupleur est reliée à l'entrée dudit premier atténuateur,

—les sorties FI des deux dits mélangeurs délivrant deux signaux représentant la partie réelle et la partie imaginaire, respectivement, de la valeur de l'onde incidente sur l'impédance Z lorsque lesdits inverseurs simple et double sont dans leurs premières positions, et la partie réelle et la partie imaginaire de la valeur de l'onde réfléchie par l'impédance Z lorsque lesdits inverseurs simple et double sont dans leurs deuxièmes positions, à partir desquelles peut être déterminé le coefficient de réflexion ρ de l'impédance Z, puis l'impédance Z par la relation

$$Z=Z_c(1+p)/(1-p).$$

Selon un mode de réalisation avantageux de l'invention, un dispositif de mesure de puissance est intercalé à l'entrée dudit second diviseur et ce dispositif de mesure est relié à un dispositif d'asservissement commandant lesdits premier et second atténuateurs variables.

La présente invention sera mieux comprise à la lecture de la description détaillée d'un mode de réalisation pris comme exemple non limitatif de illustré par le dessin annexé, sur lequel:

—la figure 1 est un bloc diagramme d'une première partie d'un appareil conforme à l'invention,

—la figure 2 est un bloc diagramme de la deuxième partie de l'appareil, venant se placer en aval de la première partie représentée sur la figure 1, et,

—la figure 3 est un schéma d'utilisation de l'appareil des figures 1 et 2 en imagerie différentielle.

L'appareil de mesure de l'invention coopère avec un générateur de puissance haute fréquence 1, pouvant délivrer une puissance variant par exemple de 1 à 1000 W (30 ù 60 dBm) à une fréquence comprise entre quelques dizaines de kHz et plusieurs MHz, et dans le cas présent entre 2 et 32 MHz par exemple. Le générateur 1 est destiné, dans l'application considérée, à alimenter des électrodes 2 que l'on dispose de façon appropriée sur des tissus vivants, afin de traiter ces tissus par hyperthermie, tout en mesurant, grâce à l'appareil de l'invention, l'impédance Z équivalente à ces tissus placés entre les électrodes 2. Entre le générateur 1 et les électrodes 2, on intercale un adaptateur d'impédance 3 de type connu, et la voie principale d'un coupleur bidirectionnel 4. Tous ces éléments, ainsi que les autres éléments de l'appareil décrits ci-dessous sont reliés entre eux par des lignes, de préférence coaxiales, présentant une impédance caractéristique $Z_c$ déterminée. Dans le cas présent, cette impédance caractéristique $Z_c$ est de 50 ohms. Ce coupleur 4 présente une atténuation d'environ 30 dB ou plus entre sa voie principale et chacune de ses voies couplées. L'une de ces voies couplées, référencée 5, mesure l'énergie envoyée aux électrodes, c'est-à-dire incidente sur l'impédance Z, l'autre voie couplée, référencée 6, mesure l'énergie réfléchie par les électrodes, c'est-à-dire réfléchie par l'impédance Z.

La voie couplée 5 est reliée via la voie principale d'un second coupleur bidirectionnel 7 au contact mobile d'un inverseur simple 8. L'un des contacts fixes de l'inverseur 8 est directement relié à la masse, alors que l'autre est relié par une charge adaptée 9 à la masse, On entend par charge adaptée une charge (généralement une résistance pur associée, le cas échéant, à des éléments réactifs de correction d'impédance) présentant dans la gamme des fréquences d'utilisation une impédance égale à l'impédance caractéristique de la ligne à laquelle elle est reliée et n'y provoquant pas d'ondes stationnaires. Dans le cas présent, cette impédance caractéristique est, comme précisé ci-dessus, de 50 ohms; et tous les coupleurs et atténuateurs décrits ici doivent également être prévus pour cette impédance caractéristique. Le coupleur 7 présente une atténuation de 3 dB entre sa voie principale et ses voies couplées 10 et 11, qui présentent les mêmes caractéristiques que les voies 6 et 5 respectivement du coupleur 4.

La voie 6 du coupleur 4 est reliée via un atténuateur 12 de 9 dB au premier contact mobile 13 d'un inverseur double 14 dont l'autre contact mobile est référencé 15. Le contact mobile 13 coopère avec un premier contact fixe qui est relié à la masse par une charge adaptée 16 et avec un second contact fixe qui est relié au premier contact fixe avec lequel coopère le contact mobile 15, le second contact fixe avec lequel

3

coopère ce contact mobile 15 étant relié à la masse par une charge adaptée 17. Le contact mobile 15 est relié à la voie couplée 10 qui mesure l'énergie de l'onde réfléchie à partir de l'inverseur simple 8.

Les contacts fixes reliés ensemble de l'inverseur 14 sont également reliés à l'entrée d'un circuit 18 à atténuation variable commandée. Dans le mode de réalisation représenté, le circuit 18 comporte deux atténuateurs 19, 20 de 10 dB chacun, reliés en cascade, chacun d'eux pouvant être court-circuité, indépendamment de l'autre, par deux commutateurs 21 et 22, respectivement. Bien entendu, le circuit 18 peut comporter un seul atténuateur à variation progressive de sont atténuation, entre 0 et 20 dB par exemple.

La sortie du circuit 18 est reliée à un contact fixe coopérant avec le premier contact mobile 23 d'un inverseur double 323. L'autre contact fixe coopérant avec le premier contact mobile 23 est relié à une borne 24 qui peut être reliée à une première sortie d'une source extérieure, qui peut par exemple être un générateur de laboratoire, fournissant dans le cas présent un signal de −6 dBm environ à cette borne 24.

Le premier contact mobile 23 de l'inverseur double 323 est relié à l'entrée d'un diviseur de puissance 25 sans déphasage entre ses sorties, réalisé par exemple, de façon connue, à l'aide d'un coupleur 3 dB 0°. Une sortie du diviseur 25 est reliée via un atténuateur 26 de 3 dB à l'entrée de signal RF d'un mélangeur 27, tandis que l'autre sortie du diviseur 25 est reliée via un atténuateur 28 de 3 dB à l'entrée RF d'un mélangeur 29.

La voie 11 du coupleur 7, qui mesure l'énergie incidente vers l'inverseur simple 8, est reliée via un atténuateur 30 de 16 dB à un atténuateur variable commandé 31, dont l'atténuation peut varier entre 3 et 30 dB par exemple. La sortie de l'atténuateur 31 est reliée par un amplificateur 32 de gain égal à 40 dB à un contact fixe coopérant avec le deuxième contact mobile 33 de l'inverseur double 323. L'autre contact fixe coopérant avec le deuxième contact mobile 33 est relié à une borne 34, qui peut être reliée à une seconde sortie de la même source extérieure que celle mentionnée ci-dessus, mais cette seconde sortie devrait fournir, dans le cas présent, un signal de +14 dBm, pour faire fonctionner de façon optimale les mélangeurs. Bien entendu, l'inverseur double 323 est agencé de telle façon que les contacts mobiles 23 et 33 sont simultanément reliés aux bornes 24 et 34 ou bien aux sorties des éléments 18 et 32.

Le contact mobile 33 est relié via un coupleur 35 à un diviseur de puissance 36 coopérant avec les mélangeurs 27 et 29.

Ce diviseur de puissance 36 présente un déphasage de 90° entre ses sorties, et il est réalisé de façon connue, par exemple à l'aide d'un coupleur 3 dB 90°, l'une de ses sorties étant reliée via un atténuateur 44 de 3 dB à l'entrée d'oscillateur local O.L. du mélangeur 27, l'autre sortie étant reliée via un atténuateur 45 de 3 dB à l'entrée d'oscillateur local O.L. du mélangeur 29. Les sorties de fréquence intermédiaire FI des mélangeurs 27 et 29 sont respectivement reliées à des bornes 46 et 47 sur lesquelles on recueille des signaux FI-1 et FI-2.

Le coupleur 35 est un coupleur dont la voie couplée est atténuée de 10 dB par rapport à la voie principale, cette voie couplée étant reliée via un atténuateur 37 de 9 dB et un circuit de détection 38, comportant une diode 39, une résistance 40 et un condensateur 41, à l'entrée d'un circuit d'asservissement 42 et à l'entrée d'un dispositif d'affichage 43. Ce dispositif 43 peut par exemple effectuer la visualisation à l'aide de diodes électro-luminescentes formant ce que l'on appelle généralement un "bar-graph", le dispositif 43 étant principalement destiné à déterminer si le niveau de l'énergie parvenant à l'élément 36 est situé ou non dans une certaine fourchette de valeurs permettant aux mélangeurs 27 et 29 de fonctionner de façon optimale.

Le circuit d'asservissement 42 commande l'atténuateur variable 18 (dans le cas présent: les commutateurs 21 et 22) et l'atténuateur variable 31, de façon à maintenir dans une fourchette de valeurs optimales les niveaux des signaux envoyés aux mélangeurs 27 et 29.

Bien entendu, toutes les valeurs d'atténuation des atténuateurs mentionnées ci-dessus sont liées aux caractéristiques des types de mélangeurs 27 et 29 utilisés. Dans le cas présent, ces mélangeurs fonctionnent de façon optimale s'ils reçoivent sur leur entrée OL un signal de +7 dBm environ (soit 5 mW) et sur leur entrée RF un signal inférieur d'au moins 20 dB à celui envoyé sur OL, soit un signal de −13 dBm environ.

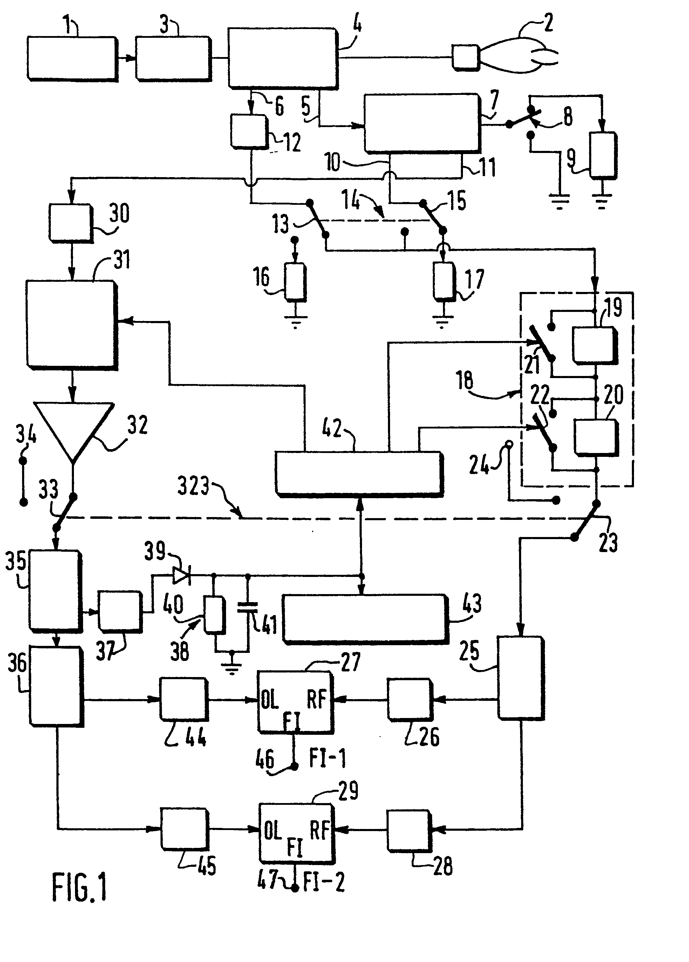

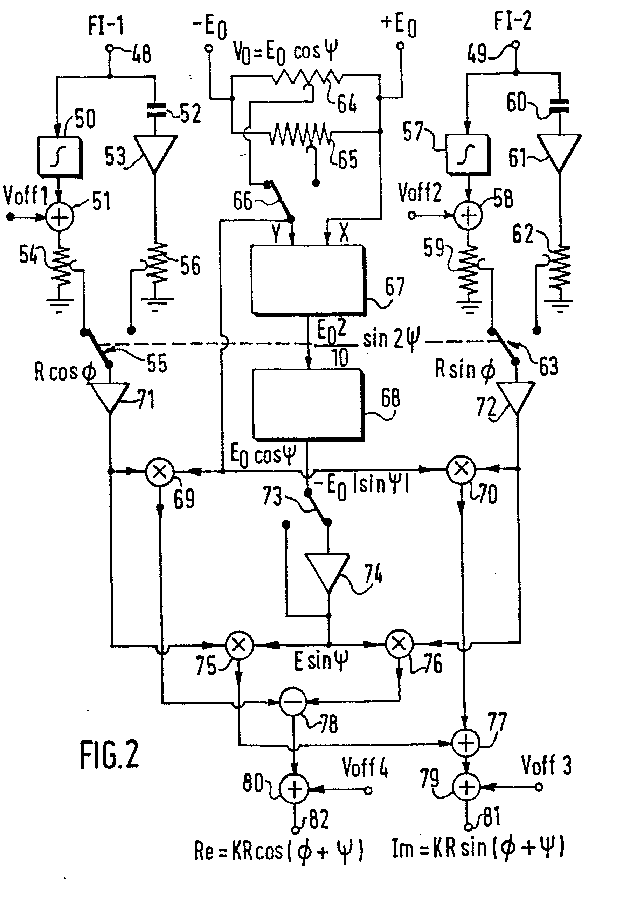

Sur la figure 2 est représenté un circuit dont les deux bornes d'entrée de signal 48, 49 sont respectivement reliées aux bornes 46, 47 du circuit de la figure 1.

La borne 48 est reliée d'une part par un filtre passe-bas 50 à une entrée d'un additionneur 51 recevant sur son autre entrée une tension continue réglable d'offset $V_{off}1$, et d'autre part par un condensateur 52 d'isolation galvanique à l'entrée d'un amplificateur à faible bruit 53. La sortie de l'additionneur 51 est reliée à la masse par un potentiomètre 54 dont le curseur est relié à un contact fixe d'un inverseur 55 dont l'autre contact fixe est relié au curseur d'un potentiomètre 56 reliant la sortie de l'amplificateur 53 à la masse.

La borne 49 est reliée à un circuit similaire à celui auquel est reliée à la borne 48, à savoir, d'une part un filtre passe-bas 57 relié à un additionneur 58, recevant d'autre part une tension continue réglable d'offset $V_{off}2$, et à un potentiomètre 59, et d'autre part un condensateur 60 suivi d'un amplificateur 61 et d'un potentiomètre 62. Les curseurs des deux potentiomètres 59, 62 sont reliés aux contacts fixes d'un inverseur 63. Les contacts mobiles des inverseurs 55 et 63 sont jumelés de façon à être en contact soit avec le curseur des potentiomètres 54 et 59 respectivement, soit avec ceux des potentiomètres 56 et 62 respectivement.

Le circuit de la figure 2 comprend également des potentiomètres 64 et 65 reliés en parallèle à des bornes portées aux potentiels continus respectifs −Eo et +Eo. Leurs curseurs sont reliés aux contacts fixes d'un inverseur 66 dont le contact mobile est relié à l'entrée Y d'un circuit 67 réalisant la fonction $(X^2-Y^2)/10$, dont l'entrée X est reliée à +Eo. Le circuit 67 est un module analogique de type connu qui réalise des opérations telles que multiplication, soustraction ou addition sur les signaux analogiques X et Y appliqués à ses entrées et délivre un signal de sortie également analogique.

Le circuit 67 est suivi d'un circuit 68 de type comparable, mais réalisant la fonction $-\sqrt{10 \cdot X}$. Le contact mobile de l'inverseur 66 est également relié aux entrées de deux multiplieurs 69 et 70 dont les autres entrées sont reliées aux sorties de deux amplificateurs 71 et 72 respectivement, dont les entrées sont reliées au contact mobile des inverseurs 55 et 63 respectivement. La sortie du circuit 68 est reliée par un inverseur 73 soit directement, soit par l'intermédiaire d'un amplificateur 74 de gain −1 aux entrées de deux autres multiplieurs 75 et 76 dont les autres entrées sont reliées aux sorties des deux amplificateurs 71 et 72 respectivement. Les sorties des multiplieurs 70 et 75 sont reliées à un additionneur 77, et les sorties des multiplieurs 69 et 76 sont reliées, à un soustracteur 78. Les sorties de l'additionneur 77 et du soustracteur 78 sont reliées via des additionneurs 79 et 80 à des bornes 81, 82, respectivement, ces additionneurs recevant des tensions continues réglables d'offset $V_{off}3$ et $V_{off}4$ respectivement.

Les bornes 81 et 82 peuvent être reliées soit à un oscilloscope sur l'écran duquel on superpose un abaque de Smith, bien connu de l'homme de métier, soit à tout dispositif approprié de traitement, pouvant calculer et afficher directement les grandeurs électriques mesurées, telles que l'impédance de la charge disposée entre les électrodes 2.

Avant d'aborder le fonctionnement détaillé, et en particulier le processus de calibration de l'appareil qui vient d'être décrit, nous en décrirons rapidement le principe de fonctionnement, les différents inverseurs étant dans la position représentée sur les figures.

Une différence entre l'impédance caractéristique $Z_c$ l'impédance Z placée entre les électrodes 2 provoque au niveau de ces dernières une réflexion de l'onde incidente, cette dernière se propageant dans le sens du générateur 1 vers les électrodes 2. Cette réflexion détermine une onde réfléchie se propageant dans un sens contraire, donc des électrodes 2 vers le générateur 1.

Le degré d'adaptation entre l'impédance caractéristique $Z_c$ connue et l'impédance Z peut être défini par le coefficient de réflexion ρ engendré par l'impédance Z. Aussi, il est procédé à une détermination préalable de ce coefficient de réflexion ρ, d'où il est possible de déduire les composantes réelle et imaginaire de l'impédance de charge Z par la relation $p=(Z-Z_c)/(Z+Z_c)$ soit $Z=Z_c (1+p)/(1-p)$.

Le coefficient de réflexion $p=R\,e^{j\phi}$ où R et φ définissent respectivement le module et la phase du coefficient, s'exprime également par la relation $\rho=R\cos\phi+j\sin\phi$ qui montre que le coefficient de réflexion comprend deux composantes en quadradure de phase.

Aussi, dans la partie de l'appareil représentée sur la figure 1, un signal relatif à l'onde incidente et un signal relatif à l'onde réfléchie sont mélangés d'une manière appropriée, pour obtenir un signal résultant comprenant deux parties en quadrature de phase; une de ces parties représentant la partie réelle (R cos φ) et l'autre partie représentant la partie imaginaire (R sin φ) du coefficient de réflexion ρ.

Le coupleur directif 4 délivre ainsi sur la voie couplée 5 un premier signal proportionnel à l'onde incidente, qui donne lieu à un deuxième signal proportionnel à l'onde incidente sur la voie couplée 11. Ce signal, après passage dans les atténuateurs 30 et 31, l'amplificateur 32 et le dispositif de mesure de puissance 35—38 est divisé dans le diviseur 36 pour engendrer deux signaux de référence déphasés de 90° appliqués aux entrées OL des mélangeurs 27 et 29 respectivement.

Le coupleur directif 4 délivre aur la voie couplée 6 un signal proportionnel à l'onde réfléchie, qui après passage dans les atténuateurs 12 et 18, est divisé dans le diviseur 25 pour engendrer deux signaux non déphasés appliqués aux entrées RF des mélangeurs 27 et 29 respectivement.

Les multiplications analogiques effectuées dans les mélangeurs 27 et 29 donnent lieu, sur les sorties à fréquence intermédiaire FI de ces mélangeurs, à des signaux dont les composantes continues dépendant des amplitudes et du déphasage relatif des signaux appliqués sur leurs entrées RF et OL respectivement.

Ainsi, en supposant que, ou cours de la procédure de calibration qui sera décrite dans la suite, on a pu compenser les différents déphasages parasites, la composante continue du signal FI-1, la seule qui est transmise au circuit de la figure 2 en aval du filtre passe-bas 50 représente la partie réelle

$$R \cos \phi$$

du coefficient de réflexion ρ alors que la composante continue du signal FI-2 représente la partie imaginaire

$$R \sin \phi$$

du coefficient de réflexion ρ.

Ainsi, le signal appliqué à l'entrée de l'amplificateur 71 représente R cos φ et le signal appliqué à l'entrée de l'amplificateur 72 représente R sin φ. Le signal sur le curseur du potentiomètre 64 est une tension $V_0$ qui peut s'écrire

$$V_0 = E_0 \cos \psi$$

expression dans laquelle l'angle ψ peut prendre toute valeur comprise entre 0 et 2 π, selon la position du curseur du potentiomètre 64.

Il est clair que le signal en sortie du circuit 67 vaut:

$$(E_0{}^2-E_0{}^2\cos^2\psi)/10$$

soit

$$(E_0{}^2\sin^2\psi)/10$$

et que le signal en sortie du circuit 68 vaut:

$$-\,-E_0\,|\sin\,\psi\,|$$

A ce niveau, l'inverseur 68 permet d'aiguiller si nécessaire ce signal vers le montage inverseur 74 de manière à obtenir $E_0\sin\psi$. En effet:

—si $\psi$ est comprise entre 0 et $\pi$, $\sin\psi\geqslant0$: on utilisé le montage inverseur 74 pour obtenir

$$+E_0\,|\sin\,\psi\,|=E=_0\sin\,\psi$$

—si $\psi$ est compris entre $\pi$ et $2\pi$, $\sin\psi\leqslant0$ et on conserve

$$-E_0\,|\sin\,\psi\,|=E_0\sin\,\psi$$

On dispose donc, comme le montre la figure 2, sur l'entrée Y du circuit 67 du signal continu

$$E_0\cos\,\psi$$

et à la sortie de l'inverseur 74 du signal continu

$$E_0\sin\,\psi$$

Ces signaux sont multipliés deux à deux avec les signaux proportionnels à $R\cos\varphi$ et $R\sin\varphi$ en sortie des amplificateurs 71 et 72 respectivement, et un calcul simple montre que les signaux en sortie de l'additionneur 77 et du soustracteur 78 valent

$$Im=KR\sin\,(\varphi+\psi)$$

$$Re=KR\cos\,(\varphi+\psi)$$

respectivement, ou K est un coefficient de proportionnalité.

Ainsi, tout se passe comme si on avait ajouté un angle de phase $\psi$, dépendant de la position du curseur du potentiomètre 64 et de la position de l'inverseur 73 à l'angle de phase $\varphi$ du coefficient de réflexion $\rho$. On désignera donc dans la suite le circuit de la figure 2, qui est en fait un circuit de traitement analogique, par l'expression "déphaseur analogique". Ce circuit est évidemment très utile dans la procédure de calibration qui va maintenant être décrite.

On va expliquer le processus de calibration de l'appareil de mesure décrit ci-dessus, le générateur 1 étant à sa puissance minimale par exemple. Ce générateur 1 est avantageusement un générateur d'impédance interne égale à l'impédance caractéristique des lignes utilisées, pouvant accepter des fortes désadaptations telles que court-circuit ou circuit ouvert, ce qui est généralement le cas d'un générateur de faible puissance. On relie l'appareil de mesure décrit ci-dessus à un oscilloscope, la sortie 82 étant reliée à l'entrée X et la sortie 81 à l'entrée Y de l'oscilloscope, et les différents inverseurs étant toujours dans la position représentée sur le dessin. Tout d'abord, on remplace les électrodes 2 par une charge adaptée et on règle les tensions $V_{off}1$ et $V_{off}2$ pour obtenir $Im=Re=0$.

Ensuite, on règle les voies de sortie des deux mélangeurs 27, 29 à l'aide des potentiomètres 54 et 59, en court-circuitant les électrodes 2. On appelle alors Rea et Ima les valeurs de Re et Im, et on règle le potentiomètre 54 pour avoir Rea et Ima de niveau suffisant, et sans saturation, ce à une fréquence quelconque comprise dans la bande de fréquences d'utilisation. On intercale ensuite une ligne $\lambda/8$ (à la fréquence considérée) entre le coupleur 4 et les électrodes 2 en court-circuit. On appelle alors Reb et Imb les valeurs de Re et Im, et on ajuste le potentiomètre 59 pour obtenir Rea=Imb, et on vérifie que, alors, Ima=−Reb.

Le court-circuit des électrodes doit être visualisé, lorsque la ligne $\lambda/8$ a été supprimée, sur l'écran de l'oscilloscope par un point en superposition avec le court-circuit indiqué par l'abaque de Smith. Généralement, à la mise en service de l'appareil, ou lors d'un changement d'électrodes et/ou de la ligne d'alimentation de ces électrodes, on n'obtient pas cette superposition, et le but de l'étape décrite juste ci-dessous du processus de calibration est de l'obtenir, afin de pouvoir ensuite lire directement sur l'abaque la valeur du coefficient de réflexion du corps disposé entre les électrodes.

Une partie de l'énergie réfléchie par les électrodes 2 en court-circuit est prélevée par la voie 6 du coupleur 4 et parvient, via le contact 13 relié à l'entrée du circuit 18, aux entrées RF des mélangeurs 27, 29. Les signaux FI-1 et FI-2 issus de ces mélangeurs parviennent au déphaseur de la figure 2, et à l'aide du potentiomètre 64 et de l'inverseur 73, on règle le déphasage de ces signaux.

Ensuite, on bascule les inverseurs 14 et 8, en branchant de préférence une charge adaptée à la place des électrodes. L'énergie incidente mesurée par la voie 5 est réfléchie par le court-circuit de l'inverseur 8, et cette énergie réfléchie est mesurée par la voie 10 du coupleur 7 pour être envoyée aux entrées RF des mélangeurs 27, 29. L'énergie incidente mesurée par les voies 5 et 11 est envoyée, comme précédemment, aux entrées OL des mélangeurs 27, 29. Le court-circuit simulé en 8 produisant généralement, au niveau des sorties 46 et 47, un déphasage différent de celui produit par le court-circuit des électrodes 2, donc un point ne coïncidant pas, sur l'écran de l'oscilloscope, avec le court-circuit indiqué par l'abaque, on obtient cette coïncidence grâce au potentiomètre 65 après avoir fait basculer l'inverseur 66. La calibration est alors terminée, et on peut procéder à la mesure en rebasculant les inverseurs 8, 14, et 66. Bien entendu, au lieu de produire un court-circuit des électrodes 2, on peut les laisser en circuit ouvert, et laisser isolé le contact fixe de l'inverseur 8, précédemment relié à la masse. On procède alors à la calibration de la façon indiquée ci-dessus en faisant coïncider dans les deux cas le point visualisé sur l'écran de l'oscilloscope avec le circuit ouvert (impédance infinie) de l'abaque.

La mesure globale de l'impédance présentée par le corps disposé entre les électrodes 2 peut alors se faire de deux façons:

1) on utilise un générateur d'impédance interne différente de l'impédance caractéristique des lignes utilisées, et ne pouvant pas accepter de fortes désadaptations. C'est le cas d'un générateur de traitement en hyperthermie pouvant délivrer une forte puissance. On mesure alors la valeur complexe B de l'onde réfléchie par le corps disposé entre les électrodes à un coefficient de proportionnalité près, les inverseurs 8, 14 et 66 étant dans la position représentée sur le dessin. On mesure ensuite, en basculant les inverseurs 8, 14 et 66 la valeur complexe—A de l'onde incidente (le signe—étant dû à la réflexion totale produite par le court-circuit de 8 qui fait que le signal ainsi réfléchi, et mesuré, est en opposition de phase avec le signal incident provenant de la voie 5). Grâce à un circuit de calcul, tel qu'un microordinateur, on calcule

$$\rho = B/A \text{ d'où } Z = Z_c \cdot (1+\rho)/(1-\rho),$$

toutes ces valeurs étant des valeurs complexes, le circuit de calcul étant branché en 81 et 82.

2) on utilise un générateur d'impédance interne égale à l'impédance caractéristique des lignes et pouvant accepter de fortes désadaptations, comme c'est le cas avec un générateur de laboratoire de faible ou moyenne puissance, et on supprime alors l'adaptateur 3. On peut alors effectuer les mesures de la même façon que dans le cas 1) ci-dessus, mais, comme il n'y a pas de réflexions multiples dans la ligne, la puissance de l'onde incidente est constante et les variations des signaux Re et Im représentent, à un coefficient de proportionnalité près, les variations du coefficient de réflexion. Au lieu d'utiliser un circuit de calcul, on peut utiliser un oscilloscope, et pour cela on relie 82 à son entrée X et 81 à son entrée Y.

Cette mesure globale d'impédance peut se faire à n'importe quel niveau de puissance du générateur 1, le dispositif d'asservissement 42 réglant les atténuateurs 18 et 31 pour que les mélangeurs 27, 29 travaillent dans leur zone de fonctionnement optimal. Connaissant l'impédance présentée par le corps, ou charge, on peut adapter au mieux le générateur à cette charge par tout moyen approprié. En outre, dans l'application à l'hyperthermie, on peut observer le processus de thermorégulation en observant les variations des caractéristiques électriques des parties du corps disposées entre les électrodes, en ayant au préalable ramené le point observé sur l'oscilloscope au centre de l'abaque de Smith, en réglant les tensions $V_{off}3$ et $V_{off}4$ et les commandes de l'oscilloscope.

Une autre application avantageuse de l'appareil de mesure de l'invention consiste en la mesure es propriétés diélectriques des tissus, à savoir leur permittivité diélectrique et leur conductivité, que l'on mesure en remplaçant les électrodes 2 par une sonde coaxiale dont l'on met l'extrémité ouverte en contact de ces tissus. La variation d'impédance ainsi provoquée est fonction des caractéristiques diélectriques de ces tissus au voisinage de l'extrémité ouverte de la sonde. On peut bien entendu suivre l'évolution de ces propriétés diélectriques en fonction de la température et du temps lors d'un traitement par hyperthermie.

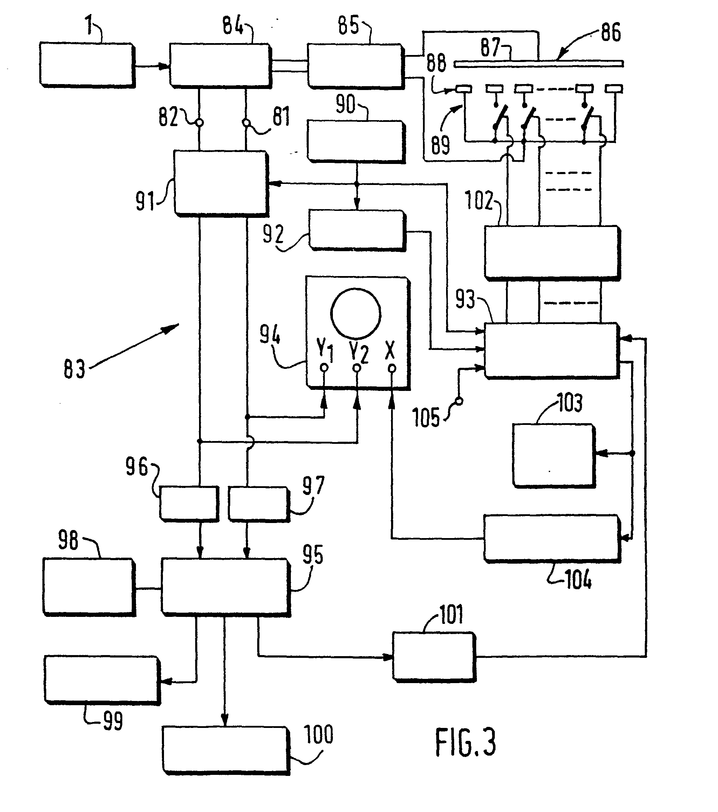

On a représenté sur la figure 3 le bloc diagramme d'un appareil de mesure 83 conforme à l'invention permettant de réaliser des mesures localisées par balayage électronique séquentiel de sondes modulées.

Cet appareil de mesure 83 est alimenté par un générateur de puissance, qui peut être le générateur 1 précité, et il comporte un réflectomètre 84 constitué des éléments 3 à 80 représentés sur les figures 1 et 2, les inverseurs 55 et 63 étant dans la position inverse de celle représentée sur le dessin, c'est-à-dire qu'ils sont en contact avec les curseurs des potentiomètres 56 et 62, qui servent dans ce cas à l'équilibrage des gains.

Au lieu de relier au coupleur 4 les électrodes classiques 2, on lui relie par l'intermédiaire d'un filtre passe-haut 85 un jeu d'électrodes spéciales 86 se composant d'une première électrode 87 ayant la forme classique d'une plaque, et d'une seconde électrode fragmentée 88, divisée en un grand nombre, par exemple 48, d'électrodes élémentaires individuelles électriquement isolées entre elles, les dimensions globales de l'électrode 88 étant les mêmes que celles de l'électrode 87. La ligne reliant le filtre 85 aux électrodes 86 est du type symétrique, l'un de ses conducteurs étant reliée à l'électrode 87, et l'autre aux électrodes élémentaires extrêmes de l'ensemble 88, ces électrodes extrêmes pouvant être par exemple au nombre de huit de chaque côté. Les autres électrodes élémentaires de l'ensemble 88 sont reliées chacune via un commutateur commandé, faisant partie d'un ensemble 89 de commutateurs, de préférence à diodes PIN, audit autre conducteur qui est relié aux électrodes élémentaires extrêmes, ces dernières ne servant pas à la mesure du fait qu'elles risquent de mesurer des phénomènes perturbés par des "effets de bords" du jeu d'électrodes 86.

L'appareil 83 comporte en outre une horloge basse fréquence 90, produisant des signaux rectantulaires ayant par exemple une fréquence de 24 kHz, et reliée à un détecteur synchrone 91, à un diviseur de fréquence 92, et à l'entrée de commande de modulation d'un modulateur 93. Les sorties 81, 82 du réflectomètre sont reliées au détecteur synchrone 91 commandé par l'horloge 90, les sorties du détecteur étant reliées aux entrées Y1 et Y2 d'un oscilloscope 94, et à un microprocesseur 94 via à chaque fois un convertisseur analogique-numérique 96, 97 respectivement. Le microprocesseur 95 est relié de façon classique à une mémoire de masse 98, à un dispositif de visualisation 99, à une imprimante 100, et à un convertisseur numérique-analogique 101 dont la sortie est reliée à l'entrée de commande de l'horloge du modulateur 93 commandant via une interface de puissance 102 les commutateurs 89. Le modulateur 93 est en ontre relié d'une part à un dispositif d'affichage 103, comportant ici deux afficheurs à sept segments, visualisant le numéro d'ordre de l'électrode élémentaire de l'ensemble 89 qui est modulée, et d'autre part à un circuit 104 de "base de temps" dont la sortie est reliée à l'entrée X de l'oscilloscope 94. Le circuit 104 est un circuit produisant, sous la commande du modulateur 93, autant de tensions continues différentes qu'il y a d'électrodes élémentaires commandées dans l'ensemble 89 (32 dans la cas précité), ces tensions étant telles que la plus faible produit, en l'absence de signaux en Y1 et Y2, un point près de l'extrémité gauche de l'axe OX, la plus élevée produisant un point près de l'extrémité droite de l'axe OX, les autres tensions produisant des points régulièrement répartis sur OX en correspondance avec les électrodes élémentaires respectives. L'entrée de commande de balayage du modulateur 93 est reliée, via un inverseur (non représenté) à la sortie du convertisseur 101, à celle du diviseur 92 et à une borne 105 sur laquelle en peut envoyer des signaux de balayage extérieurs, par exemple un balayage manuel.

L'interface de puissance 102 comporte, pour chaque commutateur de l'ensemble 89 qu'elle commande, un circuit amplificateur classique amplifiant les signaux de modulation (c'est-à-dire d'ouvertures et de fermetures successives d'un même commutateur de l'ensemble 89) produits par l'horloge 90 et transmis par le modulateur 93. Ce modulateur 93 est un démultiplexeur envoyant, au rythme de balayage des signaux de sortie du diviseur 92 (par exemple 400 Hz), les signaux de modulation aux commutateurs successifs de l'ensemble 89. Ce balayage des commutateurs peut également être effectué manuellement (borne 105) ou sous la commande du microprocesseur 95 via le convertisseur 101.

Le détecteur synchrone 91 comprend en fait un détecteur pour chacun des signaux arrivant sur les bornes 81, 82. Ces détecteurs réalisent principalement trois fonctions: l'amplification sélective du signal autour de la fréquence intermédiaire issue du mélangeur correspondant, le produit entre le signal à détecter et le signal rectangulaire issu de l'horloge 90 qui assure également la modulation des électrodes élémentaires de l'ensemble 89, et le filtrage, dans le spectre du signal produit, de la composante continue proportionnelle au signal utile.

Généralement, en hyperthermie capacitive, on effectue une mesure globale, par réflectométrie, de l'impédance interélectrode pendant les différentes phases d'un traitement sur un patient, par exemple avant et après la séance. Au début, on s'assure que le générateur est correctement adaptée sur sa charge, et à la fin on évalue les modifications d'impédance causées soit par les mouvements du patient, soit par l'élévation locale de température. En fractionnant une électrode, on fractionne l'espace de mesure, ce qui permet d'évaluer de façon plus fine les variations de grandeurs électriques en fonction de la morphologie de la partie du corps soumise au traitement, et donc d'arriver à déterminer par exemple des contours de tumeurs et d'évaluer leur évolution.

La mesure locale effectuée par l'appareil 83 décrit ci-dessus se fait selon le procédé de la perturbation modulée. Le tissu se trouvant entre les électrodes 86 est traversé, au droit de chaque électrode élémentaire excitée, par un tube de courant dont la section est imposée par les dimensions de cette électrode élémentaire. La commande du commutateur correspondant par les signaux de l'horloge 90 perturbe de courant au rythme de ces signaux. En fonction de la valeur de l'impédance de charge présente entre l'électrode 87 et l'électrode élémentaire excitée, une partie de l'énergie envoyée par le générateur 1 est réfléchie vers ce dernier. Le réflectomètre 84 permet de mesurer les variations du coefficient de réflexion ainsi engendrées. Dans le cas présent (configuration monostatique, c'est-à-dire lorsque l'onde retour empruntie au moins une partie du trajet de l'onde aller), l'information contenue dans l'onde réfléchie est proportionnelle au carré de l'intensité du tube de courant perturbé par la modulation du commutateur correspondant. En tenant compte de l'impédance de couplage entre les sondes de mesure, on montre que le carré de la valeur du courant perturbé est proportionnel à la composante quadratique de l'admittance traversée par le tube de courant, cette admittance étant mesurée à l'aide de l'appareil 83, les tensions recueillies sur les sorties du détecteur synchrone 91 étant proportionnelles aux composante quadratiques de l'admittance locale du corps soumis à la mesure. On arrive ainsi, après étalonnage de l'appareil de la façon expliquée ci-cessus, à afficher sur l'écran de l'oscilloscope 94, pour l'ensemble des électrodes 88, les parties réelle et imaginaire de l'admittance du corps mesuré à un facteur de proportionnalité près, en négligeant les impédances de couplage entre les différentes électrodes élémentaires et on peut suivre facilement ses variations locales et ses variations au cours du temps.

Cet appareil permet non seulement de déterminer l'efficacité du chauffage hyperthermique, mais également de sélectionner les électrodes les mieux adaptées à l'utilisation envisagée, de modifier leur emplacement pour mieux cerner la zone à traiter, et d'optimiser la puissance du générateur 1.

Moyennant des aménagements à la portée de l'homme de l'art, on peut utiliser le microprocesseur 95 pour connaître les paramètres nécessaires à la bonne adaptation du générateur sur la charge, malgré les mouvements, la sudation du patient, et les modifications des caractéristiques électriques de la charge en fonction de l'élévation de la température, ces paramètres étant les parties réelle et imaginaire, le module et la phase de l'admittance du corps disposé entre les électrodes.

L'appareil de mesure 83 permet également, si l'on introduit dans les tissus soumis à la mesure, dans le trajet des tubes de courant des électrodes élémentaires, un petit dipôle dont les pôles sont reliés par une diode, ou une petite boucle refermée par une diode, de faire des mesures locales relatives de champ électrique ou magnétique, respectivement.

Naturellement, et comme cala a déjà été signalé, les applications de l'appareil de l'invention ne sont pas limitées à la mesure d'impédances de tissus vivants, et peuvent concerner toutes autres applications, notamment industrielles.

**Revendications**

1. Appareil de mesure d'impédance en haute fréquence, comportant au moins un coupleur bidirectionnel (4, 7), un générateur (1) d'une onde haute fréquence de puissance variable, des atténuateurs variables (18, 31), deux mélangeurs (27, 29), des diviseurs de puissance (25, 36), dont l'un (36) est un diviseur de puissance à déphasage de 90° entre ses deux sorties, chacune d'elles étant reliée à une entrée d'un respectif des deux mélangeurs, caractérisé par le fait que:

—un premier coupleur (4) bidirectionnel est intercalé, à l'aide de tronçons de lignes d'impédance caractéristique $Z_c$ connue, entre le générateur (1) d'une onde haute fréquence de puissance variable et des électrodes (2) entre lesquelles est placé un corps dont l'impédance Z, inconnue, est à mesurer,

—la première voie couplée (5) dudit premier coupleur (4), mesurant l'onde incidente sur l'impédance Z, est reliée, par l'intermédiaire d'un second coupleur bidirectionnel (7) et d'un inverseur simple (8), soit à une impédance d'un des types suivants: impédance nulle et impédance pratiquement infinie, soit à une première charge adaptée (9),

—la seconde voie couplée (6) dudit premier coupleur (4), mesurant l'onde réfléchie par l'impédance Z, est reliée, par l'intermédiaire d'un premier inverseur d'un inverseur double (14), soit à une deuxième charge adaptée (16), soit, par l'intermédiaire d'un premier atténuateur variable (18), à l'entrée d'un premier diviseur de puissance (25) sans déphasage entre ses deux sorties reliées aux entrées RF des deux mélangeurs (27, 29),

—la première voie couplée (11) dudit second coupleur (7), mesurant l'onde incidente vers ledit inverseur simple (8), est reliée, par l'intermédiaire d'un second atténuateur variable (31), à l'entrée un second diviseur de puissance (36) à déphasage de 90° entre ses deux sorties reliées aux entrées d'oscillateur local OL des deux dits mélangeurs (27, 29),

—la seconde voie couplée (10) dudit second coupleur (7), mesurant l'onde réfléchie à partir dudit inverseur simple (8), étant reliée, par l'intermédiaire du deuxième inverseur dudit inverseur double (14), soit à l'entrée dudit premier atténuateur (18) lorsque ladite seconde voie couplée (6) dudit premier coupleur (4) est reliée à ladite deuxième charge adaptée (16), soit à une troisième charge adaptée (17) lorsque ladite seconde voie couplée (6) dudit premier coupleur (4) est reliée à l'entrée dudit premier atténuateur (18),

—les sorties FI (46, 47) des deux dits mélangeurs (27, 29) délivrant deux signaux représentant la partie réelle et la partie imaginaire, respectivement, de la valeur de l'onde incidente sur l'impédance Z lorsque lesdits inverseurs simple (18) et double (14) sont dans leurs premières positions, et la partie réelle et la partie imaginaire de la valeur de l'onde réfléchie par l'impédance Z lorsque lesdits inverseurs simple (18) et double (14) sont dans leurs deuxièmes positions, à partir desquelles peut être déterminé le coefficient de réflexion ρ de l'impédance Z, puis l'impédance Z par la relation

$$Z = Z_c\ (1+\rho)/(1-\rho).$$

2. Appareil de mesure selon la revendication 1, dans lequel un dispositif de mesure de puissance (35—38) est intercalé à l'entrée dudit second diviseur (36), et ce dispositif de mesure est relié à un dispositif d'asservissement (42) commandant lesdits premier (18) et second (31) atténuateurs variables.

3. Appareil de mesure selon la revendication 2, dans lequel lesdits mélangeurs (27, 29) sont d'un type présentant un fonctionnement optimal lorsque leur signal d'oscillateur local a un niveau d'environ +7 dBm et est supérieur d'environ 20 dB au moins un signal RF, ledit générateur (1) délivre une puissance comprise entre sensiblement 30 et sensiblement 60 dBm, le premier coupleur (4) a un coefficient de couplage de 30 dB, le second coupleur (7) a un coefficient de couplage de 3 dB, un atténuateur de sensiblement 9 dB (12) est inséré dans la seconde voie couplée (6) dudit premier coupleur (4), dans la première voie couplée (11) dudit second coupleur (7) est inséré un atténuateur de sensiblement 16 dB (30) en amont dudit second atténuateur variable (31), et un amplificateur de sensiblement 40 dB (32) en aval de cet atténuateur (31), le premier atténuateur variable (18) a une atténuation pouvant varier de 0 à 20 dB environ et le second atténuateur variable (31) une atténuation pouvant varier de 3 à 30 dB environ, un atténuateur de sensiblement 3 dB (26, 28, 44, 45) étant inséré entre chaque sortie desdits diviseurs de puissance (25, 36) et l'entrée correspondante du mélangeur (27, 29) correspondant.

4. Appareil de mesure selon l'une des revendications 1 à 3, dans lequel est disposé auxdites sorties FI (46, 47) desdits mélangeurs (27, 29) un déphaseur analogique (48 à 82).

5. Appareil de mesure selon la revendication 4, dans lequel le déphaseur analogique (48 à 82) comporte deux réglages différentes de déphasage (64, 65) commutés à l'aide d'un deuxième inverseur simple (66) actionné en même temps que ledit premier inverseur simple (8) et ledit inverseur double (14).

6. Appareil de mesure selon l'une des revendications 1 à 5, dans lequel l'une des électrodes est fragmentée en un grand nombre d'électrodes élémentaires (88) électriquement isolées entre elles, chacune de ces électrodes élémentaires étant reliée à son conducteur d'alimentation par un commutateur commandé (89) par un modulateur (93) recevant des signaux de modulation d'une horloge (90), cette horloge étant reliée à un détecteur synchrone (91) disposé à la sortie de l'appareil de mesure.

7. Appareil de mesure (83) selon la revendication 6, dans lequel l'horloge (90) est reliée par un diviseur de fréquence (92) à une entrée de commande de balayage des électrodes élémentaires (88) du modulateur (93).

8. Appareil (83) selon l'une des revendications 6 ou 7, dans lequel un filtre passe-haut (85) et une ligne symétrique sont intercalés en amont desdites électrodes (2).

9. Appareil (83) selon l'une des revendications 6 à 8, dans lequel les sorties du détecteur synchrone (91) sont reliées à deux entrées ($Y_1$, $Y_2$) de déviation verticale d'un oscilloscope (94), dont l'entrée de déviation horizontale (X) est reliée à une sortie du modulateur (93) via un circuit de base de temps (104) discrétisant et affichant sur l'écran de l'oscilloscope les signaux relatifs à chacune des électrodes élémentaires (88) excitées.

10. Appareil (83) selon l'une des revendications 6 à 9, dans lequel les sorties du détecteur synchrone (91) sont reliées chacune par un convertisseur analogique-numérique (96, 97) à un microprocesseur (95), lui-même relié par un convertisseur numérique-analogique (101) à une entrée de commande de balayage de modulateur (93).

**Patentansprüche**

1. Hochfrequenz-Impedanzmeßgerät mit mindestens einem Zweirichtungskoppler (4, 7), einem Hochfrequenzgenerator (1) variabler Leistung, variablen Dämpfungsgliedern (18, 31), zwei Mischer (27, 29), Leistungsteilern (25, 36), von welchen einer (36) ein Leistungsteiler mit 90° Phasenverschiebung zwischen seinen beiden Ausgängen ist, von welchen jeder mit einem Eingang einer bzw. beider Mischer verbunden ist, dadurch gekennzeichnet, daß

—ein erster Zweirichtungskoppler (4) mittels Leitungsstücken mit bekanntem Wellenwiderstand $Z_c$ zwischen dem Hochfrequenzgenerator (1) variabler Leistung und Elektroden (2) eingeschaltet ist, zwischen welchen sich ein Körper befindet, dessen unbekannte Impedanz Z gemessen werden soll,

—der erste gerichtete Kanal (5) des ersten Kopplers (4), welcher die auf die Impedanz Z auftreffende Welle mißt, über einen zweiten Zweirichtungskoppler (7) und einen Einfach-Inverter (8) entweder mit einer Impedanz von der Art einer Nullimpedanz oder praktisch unendlichen Impedanz, oder mit einer ersten angepaßten Last (9) verbunden ist,

—der zweite gerichtete Kanal (6) des ersten Kopplers (4), welcher die von der Impedanz Z reflektierte Welle mißt, über einen ersten Inverter eines Doppel-Inverters (14) entweder mit einer zweiten angepaßten Last (16) verbunden ist oder über ein erstes variables Dämpfungsglied (18) mit dem Eingang eines ersten Leistungstellers (25) ohne Phasenverschiebung zwischen seinen beiden mit den Eingängen RF der beiden Mischer (27, 29) verbundenen Ausgängen,

—der erste gekoppelte Kanal (11) des genannten zweiten Kopplers (7), welcher die in Richtung auf den Einfach-Inverter (8) auftreffende Welle mißt, über ein zweites variables Dämpfungsglied (31) mit dem Eingang eines zweiten Leistungsteilers (36) mit 90° Phasenverschiebung zwischen seinen beiden; mit den Lokaloszillator-Eingängen OL der beiden Mischer (27, 29) verbundenen Ausgängen verbunden ist,

—der zweite gerichtete Kanal (10) des genannten zweiten Kopplers (7), welcher die reflektierte Welle ab dem genannten Einfach-Inverter (8) mißt, über den zweiten Inverter des Doppel-Inverters (14) entweder mit dem Eingang des genannten ersten Dämpfungsgliedes (18) verbunden ist, wenn der genannte zweite gerichtete Kanal (6) des ersten Kopplers (4) mit der zweiten angepaßten Last (16) verbunden ist oder mit einer dritten angepaßten Last (17), wenn der zweite gerichtete Kanal (6) des ersten Kopplers (4) mit dem Eingang des ersten Dämpfungsgliedes (18) verbunden ist,

—die Ausgänge FI (46, 47) der beiden Mischer (27, 29) zwei Signale liefern, die den Real- bzw. Imaginärteil des Wertes der auf die Impedanz Z auftreffenden Welle darstellen, wenn sich die genannten Einfach-Inverter (8) und Doppel-Inverter (14) in ihrer ersten Stellung befinden und den Real- und Imaginärteil des von der Impedanz Z reflektierten Wellenwerts, wenn sich die Einfach-Inverter (18) und Doppel-Inverter (14) in ihrer zweiten Position befinden, von welchen aus der Reflexionskoeffizient ρ der Impedanz Z bestimmt werden kann und dann die Impedanz Z durch die Relation

# EP 0 214 015 B1

$$Z = Z_c \, (1+\rho)/(1-\rho)$$

2. Meßgerät gemäß Anspruch 1, bei welchem ein Leistungsmeßgerät (35—38) an den Eingang des zweiten Teilers (36) geschaltet ist, und dieses Meßgerät mit einer Regeleinrichtung (42) verbunden ist, welche die genannten ersten (18) und zweiten (31) variablen Dämpfungsglieder steuert.

3. Meßgerät gemäß Anspruch 2, bei welchem die Mischer (27, 29) dann optimal funktionieren, wenn ihr Oszillatorempfangssignal ungefähr +7 dBm beträgt und zumindest um ungefähr 20 dB über dem RF-Signal liegt, der Generator (1) eine zwischen 30 und 60 dBm liegende Leistung liefert, der erste Koppler (4) einen Kopplungskoeffizienten von 30 dB aufweist, der zweite Koppler (7) einen Kopplungskoeffizienten von 3 dB, ein Dämpfungsglied von 9 dB (12) in den zweiten gerichteten Kanal (6) des ersten Kopplers (4) eingesetzt ist, in den ersten gerichteten Kanal (11) des zweiten Kopplers (7) ein Dämpfungsglied von 16 dB (30) oberhalb des genannten zweiten variablen Dämpfungsgliedes (31) eingesetzt ist und ein Versträkersglied von 40 dB (32) unterhalb dieses Dämpfungsgliedes (31), und das erste variable Dämpfungsglied (18) eine Dämpfung aufweist, die zwischen 0 und 20 dB liegen kann und das zweite variable Dämpfungsglied (31) eine Dämpfung, die zweiten 3 und 30 dB liegen kann, wobei ein Dämpfungsglied von 3 dB (26, 28, 44, 45) zwischen jeden Ausgang der Leistungsteiler (25, 36) und dem entsprechenden Eingang der entsprechenden Mischer (27, 29) geschaltet ist.

4. Meßgerät gemäß einem der Ansprüche 1 bis 3, bei welchem an den Ausgängen FI (46, 47) der Mischer (27, 29) ein Analog-Phasenschieber (48—82) angeordnet ist.

5. Meßgerät gemäß Anspruch 4, bei welchem der Analog-Phasenschieber (48—82) zwei verschiedene Steuerungen (64, 65) zur Phasenverschiebung aufweist, welche mit Hilfe eines zweiten Einfach-Inverters (66) geschaltet werden, der gleichzeitig mit dem ersten Einfach-Inverter (8) und dem Doppel-Inverter (14) betätigt wird.

6. Meßgerät gemäß einem der Ansprüche 1 bis 5, bei welchem eine der Elektroden in einer große Anzahl von untereinander elektrisch isolierten Teilelektroden (88) aufgeteilt ist, wobei jede dieser Teilelektroden mit ihrer Anspeiseleitung durch einen Schalter (89) verbunden ist, welcher von einem Modulator (93) gesteuert wird, der von einem Zeitgeber (90) Modulationssignale erhält, wobei dieser Zeitgeber mit einem am Ausgang des Meßgerätes angeordneten Synchrondetektor (91) verbunden ist.

7. Meßgerät (83) gemäß Anspruch 6, bei welchem der Zeitgeber (90) durch einen Frequenzteiler (92) mit einem Eingang zur Steuerung der Abtastung der Teilelektroden (88) des Modulators (93) verbunden ist.

8. Gerät (83) gemäß einem der Ansprüche 6 oder 7, bei welchem ein Hochpaßfilter (85) und ein symmetrischer Leiter oberhalb der genannten Elektroden (2) in den Stromkreis geschaltet sind.

9. Gerät (83) gemäß einem der Ansprüche 6 bis 8, bei welchem die Ausgänge des Synchrondetektors (91) mit zwei Y-Ablenkeingängen (Y1, Y2) eines Oszilloskops (94) verbunden sind, dessen X-Ablenkeingang (X) mit einem Ausgang des Modulators (93) verbunden ist über eine Zeitbasisschaltung (104), die auf dem Schirm des Oszilloskops die jeder der erregten Elementarelektroden (88) zugeordneten Signale anzeigt.

10. Gerät (83) gemäß einem der Ansprüche 6 bis 9, bei welchem die Ausgange des Synchrondetektors (91) jeweils über einen Analog/Digital-Wandler (96, 97) mit einem Mikroprozessor (95) verbunden sind, welcher selbst durch einen Digital/Analog-Wandler (101) mit einem Abtaststeuereingang des Modulators (93) verbunden ist.

**Claims**

1. High frequency impedance measurement apparatus comprising at least a bidirectional coupler (4, 7), a generator (1) generating a high frequency wave of variable power, variable attenuators (18, 31), two mixers (27, 29), power dividers (25, 36), one (36) of which is a power divider with a phase shift of 90 degrees between its two outputs, each of which being connected to one output of one respective of the two mixers, characterized in that:
—a first bidirectional coupler (4) is inserted, by means of line sections having a known characteristic impedance $Z_c$. between the generator (1) generating a high frequency wave of variable power and electrodes (2) between which is placed a body whose impedance Z, unknown, is to be measured,
—the first coupled channel (5) of said first coupler (4) measuring the incident wave on the impedance Z, is connected through a second bidirectional coupler (7) and a single inverter (8), either to an impedance of one of the following types: a zero impedance, a practically infinite impedance, or to a first matched load (9),
—the second coupled channel (6) of said first coupler (4) measuring the wave reflected by the impedance Z, is connected through a first inverter of a double inverter (14), either to a second matched load (16) or, through a first variable attenuator (18), to the input of a first power divider (25) without phase shift between its two outputs connected to the RF inputs of the two mixers (27, 29),
—the first coupled (11) channel of said second coupler (7) measuring the incident wave towards said single inverter (8), is connected through a second variable attenuator (31) to the input of a second power divider (36) with a phase shift of 90 degrees between its two outputs connected to the local oscillator LO input of said two mixers (27, 29),
—the second coupled channel (10) of said second coupler (7) measuring the wave reflected from said single inverter (8) being connected through the second inverter of said double inverter (14), either to the input of said first attenuator (18) when said second coupled channel (6) of said first coupler (4) is connected

11

to said second matched load (16), or to a third matched load (17) when said second coupled channel (6) of said first coupler (4) is connected to the input of said first attenuator (18),

—the IF output (46, 47) of said two mixers (27, 29) delivering two signals representing the real part and the imaginary part, respectively, of the value of the incident wave on the impedance Z when said single (8) and double (44) inverters are in their first positions, and the real part and the imaginary part of the value of the wave reflected by the impedance Z when said single (8) and double (14) inverters are in their second position, from which may be determined the coefficient (ρ) of reflection of impedance Z. then impedance Z by the relationship

$$Z=Z_c \,(1+\rho)/(1-\rho)$$

2. Measurement apparatus as claimed in claim 1, wherein a power measuring device (35—38) is inserted at the input of said second divider 36, and this measuring device is connected to a control device (42) controlling said first (18) and second (31) variable attenuators.

3. Measurement apparatus as claimed in claim 2, wherein said mixers (27, 29) are of a type having optimum operation when their local oscillator signal has a level of about +7 dBm and is greater by about at least 20 dB than an applied RF signal, said generator (1) delivers power between substantially 30 and substantially 60 dBm, the first coupler (4) has a coupling coefficient of 30 dB, the second coupler (7) has a coupling coefficient of 3 dB, an attenuator of substantially 9 dB (12) is inserted in the second coupled channel (6) of said first coupler (4), in the first coupled channel (11) of said second coupler (7) is inserted an attenuator of substantially 16 dB (30) upstream of said second variable attenuator (31) and an amplifier (32) of substantially 40 dB down-stream of that attenuator (31), the first variable attenuator (18) has an attenuation which may vary from 0 to about 20 dB and the second variable attenuator (31) has an attenuation which may vary from 3 to about 30 dB, an attenuator of substantially 3 dB (26, 28, 44, 45) being inserted between each output of said power dividers (25, 36) and the corresponding input of the corresponding mixer (27, 29).

4. Measurement apparatus as claimed in one of claims 1 to 3, wherein an analog phase shifting (48—82) circuit is disposed at said IF outputs (46, 47) of said mixers (27, 29).

5. Measurement apparatus as claimed in claim 4, wherein the analog phase shifting circuit (48—82) has two different phase shift adjustments (64, 65) switched by means of a second single inverter (66) actuated at the same time as said first single inverter (8) and as said double inverter (14).

6. Measurement apparatus as claimed in one of claims 1 to 5, wherein one of the electrodes is fragmented into a large number of elementary electrodes (88) electrically isolated from each other, each of these elementary electrodes being connected to its power supply conductor by a switch (89) controlled by a modulator (93) receiving modulation signals from a clock (90), this clock being connected to a synchronous detector (91) disposed at the output of the measurement apparatus.

7. Measurement apparatus (83) as claimed in claim 6, wherein the clock (90) is connected by a frequency divider (92) to a scanning control input of the elementary electrodes (88) of the modulator (93).

8. Apparatus (83) as claimed in one of claims 6 or 7, wherein a low pass filter (85) and a symmetric line are inserted upstream of said electrodes (2).

9. Apparatus (83) as claimed in one of claim 6 to 8, wherein the outputs of the synchronous detector (91) are connected to two vertical deflection inputs (Y1, Y2) of an oscilloscope (94), whose horizontal deflection input (X) is connected to an output of the modulator (93) via a time base circuit (104) discretizing and displaying on the screen of the oscilloscope the signals relative to each of the elementary electrodes (88) energized.

10. Apparatus (83) as claimed in one of claim 6 to 9, wherein the outputs of the synchronous detector (91) are each connected by an analog-digital converter (96—97) to a microprocessor (95), itself connected by a digital-analog convertor (101) to a scanning control input of the modulator (93).

FIG.1

FIG.2

EP 0 214 015 B1

FIG.3